# EUROPÄISCHE PATENTSCHRIFT

(11) **EP 2 737 326 B1**
(45) Veröffentlichungstag und Bekanntmachung des Hinweises auf die Patenterteilung: **26.06.2019**
(21) Anmeldenummer: 12740589.2
(22) Anmeldetag: 26.07.2012
(51) Int. Cl.: G01R 19/00, G01R 31/36, G01R 1/20, B60R 16/033, H02G 3/18, H05K 13/00

(54) **SCHALTUNG ZUM LEITEN EINES ELEKTRISCHEN STROMES**
CIRCUIT FOR CONDUCTING AN ELECTRIC CURRENT
CIRCUIT DE CONDUCTION D'UN COURANT ÉLECTRIQUE

(30) Priorität: 28.07.2011 DE 102011079966
(43) Veröffentlichungstag der Anmeldung: 04.06.2014
(73) Patentinhaber: Continental Teves AG & Co. OHG, 60488 Frankfurt am Main (DE)
(72) Erfinder: SCHILLINGER, Jakob, 85080 Gaimersheim (DE); HUBER, Dietmar, 63322 Rödermark (DE); RINK, Klaus, Rodenbach 63517 (DE); JÖCKEL, Wolfgang, 36129 Gersfeld (DE); HAVERKAMP, Martin, 60385 Frankfurt (DE)
(86) Internationale Anmeldenummer: PCT/EP2012/064709
(87) Internationale Veröffentlichungsnummer: WO 2013/014240

(56) Entgegenhaltungen:
- WO-A1-2013/007834
- DE-A1- 10 118 027
- DE-A1- 19 736 025
- DE-A1-102004 007 851
- DE-A1-102005 043 320
- FR-A1- 2 879 751
- JP-A- 2009 236 641
- US-A1- 2008 238 431
- US-A1- 2010 316 901
- US-B1- 6 304 062

## Beschreibung

Die Erfindung betrifft eine Schaltung zum Leiten eines elektrischen Stromes zwischen einer Fahrzeugbatterie und einer an die Fahrzeugbatterie anschließbaren elektrischen Netzwerkkomponente über ein elektrisches Bauelement sowie ein Fahrzeug mit der Schaltung.

Zur Durchführung von Messungen eines von einer elektrischen Energiequelle an einen elektrischen Verbraucher abgegebenen elektrischen Stromes in einem Kraftfahrzeug können in Reihe zwischen der elektrischen Energiequelle und den elektrischen Verbraucher ein zwischen zwei Leitungsabschnitten angeordneter Stromsensor geschaltet werden. Der Stromsensor hat beispielsweise einen Messwiderstand, wobei aus dem elektrischen Widerstand des Messwiderstandes und der über den Messwiderstand abfallenden Spannung die Stromstärke des elektrischen Stroms ermittelt wird. Ein derartiger Stromsensor ist beispielsweise aus der DE 10 2011 078 548 A1, der DE 10 2005 043 320 A1, der DE 197 36 025 C2, der US 6,304,062 B1, der US 2008/238431 A1, der JP 2009 236 641 A1, der Fr 2 879 751 A1 und der US 2010/316901 A1 bekannt.

In der DE 101 18 027 A1 ist ein Stromsensor gezeigt, bei dem die Leitungsabschnitte durch einen Isolator voneinander getrennt sind, wobei der Abstand zwischen den leitungsabschnitten von einer Durchschlagsfeldstärke des Abstandshalters abhängig ist.

Ein weiterer Stromsensor ist in der am 17.01.2013 veröffentlichten WO 2013/007 834 A1 gezeigt.

Stromsensoren müssen in Reihe zwischen der elektrischen Energiequelle und den elektrischen Verbrauchern geschalten werden.

Es ist Aufgabe der vorliegenden Erfindung diese Schaltung der Stromsensoren in Reihe zwischen Energiequelle und Verbraucher zu verbessern.

Die Aufgabe wird durch die Merkmale der unabhängigen Ansprüche gelöst. Bevorzugte Weiterbildungen sind Gegenstand der abhängigen Ansprüche.

Die Erfindung schlägt eine Schaltung zum Leiten eines elektrischen Stromes zwischen einer Fahrzeugbatterie und einer an die Fahrzeugbatterie anschließbaren elektrischen Netzwerkkomponente über ein elektrisches Bauelement vor, die einen ersten elektrischen Leitungsabschnitt und einen über einen Abstandshalter vom ersten Leitungsabschnitt getrennten zweiten Leitungsabschnitt umfasst, wobei die Leitungsabschnitte über das elektrische Bauelement miteinander verbunden sind.

Das elektrische Bauelement kann im Rahmen der Erfindung jedes beliebige Bauelement sein, das zwischen die Fahrzeugbatterie und die elektrische Netzwerkkomponente geschaltet werden kann. So kann das elektrische Bauelement beispielsweise der eingangs genannte Stromsensor, ein Filter zur Verbesserung der elektromagnetischen Verträglichkeit (EMV genannt), eine Schutzdiode und/oder ein Temperatursensor sein, der zum Schutz anderer elektrischer Bauelemente die Umgebungstemperatur überwacht. Der Stromsensor kann dabei im Rahmen einer Strommessung, einer Ladestromregelung, einer Stromanstiegsbegrenzung oder im Rahmen eines Stromschalters verwendet werden. Der Stromsensor und die entsprechenden Anwendungen können unidirektional oder bidirektional ausgeführt werden.

In gleicher Weise kann die elektrische Netzwerkkomponente neben der Fahrzeugbatterie jedes beliebige elektrische Bauelement wie eine elektrische Energiequelle in Form eines Generators, einer Steckdose oder einer weiteren Batterie oder ein elektrischer Verbraucher, wie beispielsweise ein elektrisches Fahrzeugboardnetz oder ein Elektromotor sein.

Der angegebenen Schaltung liegt die Überlegung zugrunde, dass das elektrische Bauelement direkt zwischen die Fahrzeugbatterie und die elektrische Netzwerkkomponente geschaltet werden könnte. Dieser Überlegung liegt jedoch die Erkenntnis zugrunde, dass die elektrische Verbindung gleichzeitig auch die mechanische Festigkeit zwischen der Fahrzeugbatterie und der elektrischen Netzwerkkomponente übernehmen müsste. Daher wird mit der angegebenen Schaltung vorgeschlagen, das elektrische Bauelement zwischen die Fahrzeugbatterie und die andere elektrische Netzwerkkomponente über Leitungsabschnitte elektrisch zu kontaktieren, die über einen Abstandshalter voneinander auf einem vordefinierten Abstand gehalten werden. Auf diese Weise können mechanische Belastungen, die beispielsweise durch Wärmearbeit, Erschütterungen oder andere mechanische Störungen auf die Schaltung eingebracht werden, vom Abstandshalter aufgenommen werden, so dass die elektrische Verbindung zwischen den Leitungsabschnitten und dem elektrischen Bauelement vor mechanischen Belastungen und damit vor mechanischen Spannungen geschützt ist. Der Abstand zwischen dem ersten Leitungsabschnitt und dem zweiten Leitungsabschnitt ist von einer Durchschlagsfeldstärke des Abstandshalters abhängig. Die Leitungsabschnitte sind miteinander labyrinthartig verzahnt.

Durch die angegebene Schaltung wird das elektrische Bauelement zwischen der Fahrzeugbatterie und der anderen elektrischen Netzwerkkomponente dauerhaft und beständig elektrisch verschaltet, wodurch die elektrische Verbindung der Fahrzeugbatterie und der anderen elektrischen Netzwerkkomponente zuverlässiger ausgebildet werden kann.

Mit der labyrinthartigen Verzahnung werden die Leitungsabschnitte miteinander verschränkt, um eine feste mechanische Kopplung der Leitungsabschnitte über den Abstandshalter und eine geringe thermische Ausdehnung der Verbindungszonen zwischen den Leitungsabschnitten zu erreichen, die sich aufgrund der nun sehr dünnen Leitungsabschnitte einstellt.

In einer zusätzlichen Weiterbildung der angegebenen Schaltung ist die labyrintartige Verzahnung der Leitungsabschnitte federnd ausgebildet. Auf diese Weise können die Leitungsabschnitte einen verbleibenden Rest an mechanischen Belastungen selbst aufnehmen und so vermeiden, dass die elektrischen Kontaktierungsstellen des über die Leitungsabschnitte elektrisch zu kontaktierenden elektrischen Bauelementes außerhalb der labyrintartigen Verzahnung mit mechanisch belastet wird.

In einer anderen Weiterbildung der angegebenen Schaltung ist der Abstandshalter aus einem Premoldmaterial ausgebildet. Unter einem Premoldmaterial soll ein Material verstanden werden, dass in einem geschmolzenen Aggregatzustand zwischen die beiden Leitungsabschnitte eingesetzt wird und dann zwischen den beiden Leitungsabschnitten erhärtet. Derartige Premoldmaterialien können beispielsweise Duroplaste als auch Thermoplaste sein. Mit dem Premoldmaterial lässt sich der Abstandshalter mit sehr genauen Abmaßen ausbilden, so dass der Abstandshalter die beiden Leitungsabschnitte in einem mechanisch belastungsfreien Zustand zwischen den beiden Leitungsabschnitten nicht unnötig gegeneinander mechanisch verspannt.

In einer bevorzugten Weiterbildung der angegebenen Schaltung umschließt das Premoldmaterial eine Oberfläche der elektrischen Leitungsabschnitte derart, dass eine Öffnung zum elektrischen Kontaktieren des elektrischen Bauelements auf den Leitungsabschnitten frei bleibt. Auf diese Weise kann eine noch bessere mechanische Fixierung der elektrischen Leitungsabschnitte und damit eine mechanisch noch spannungsfreiere Zone für das elektrische Bauelement und seine elektrische Verbindung mit den elektrischen Leitungsabschnitten geschaffen werden.

In einer anderen Weiterbildung der angegebenen Schaltung ist ein Abstand zwischen dem ersten Leitungsabschnitt und dem zweiten Leitungsabschnitt von einer Durchschlagsfeldstärke des Abstandshalters abhängig. Die Abhängigkeit ist dabei insbesondere derart ausgebildet, dass der Abstand umso größer ist, je kleiner die Durchschlagsfeldstärke des Abstandshalters ist. Besonders bevorzugt ist der Abstand dabei ausreichend groß gewählt, dass zwischen den Leitungsabschnitten kein elektrischer Überschlag auftreten kann.

Die Leitungsabschnitte können aus Kupfer, Aluminium, Eisen, Nickel und deren Legierungen bestehen. Vordergründig ist der Temperaturkoeffizient und die Wärmeleitfähigkeit für die Auswahl wichtig.

In einer noch anderen Weiterbildung der angegebenen Schaltung sind die Kontaktflächen auf den Leitungsabschnitten zum Kontaktieren des elektrischen Bauelementes beschichtet. Als Beschichtungsmaterialen können dabei Metalle oder Metalllegierungen gewählt werden, über die die elektrische Kontaktierung des elektrischen Bauelements mit dem entsprechenden Leitungsabschnitt unterstützen. Derartige Metalle oder Metalllegierungen können Legierungen sein, die auf Kupfer oder einer Mischung aus Kupfer und Nickel basieren, wie Cu-Ni-SN, Cu-Sn, Cu-Ni-Au, Cu-Ni-Pd-Au oder Cu-Ag. Die Kontaktflächen auf den elektrischen Leitungsabschnitten können dabei vor der elektrischen Kontaktierung insbesondere mit CO₂ durch Stahlen, mit Plasma oder mit einem Laser gereinigt werden. Zur Kontaktierung selbst können die elektrischen Bauelemente per Sintern, Kleben oder Löten auf die elektrischen Leitungsabschnitte aufgebracht werden.

In einer bevorzugten Weiterbildung der angegeben Schaltung umfasst die angegebene Schaltung das elektrische Bauelement, das mit einer Schutzmasse bedeckt ist. Die Schutzmasse, die auch als Globetop oder Sil-Gel ausgebildet sein kann, schützt und isoliert das elektrische Bauelement dauerhaft insbesondere vor Feuchtigkeit und Verunreinigungen, die zu elektrischen Fehlfunktionen des elektrischen Bauelementes führen könnten.

In einer besonders bevorzugten Weiterbildung der angegebenen Schaltung sind die Leitungsabschnitte auf einem Bauteilträger, Leadframe genannt, getragen. Auf diesem Leadframe können mehrere Schaltungen gleichzeitig getragen und damit in Massenproduktion hergestellt werden, wobei die einzelnen Schaltungen letztendlich dann nur noch durch trennen voneinander separiert werden brauchen.

Die Erfindung gibt auch ein Fahrzeug an, das
- eine Fahrzeugbatterie,
- eine an die Fahrzeugbatterie angeschlossene elektrische Netzwerkkomponente und
- eine der angegebenen Schaltungen umfasst, die zwischen die Fahrzeugbatterie und die elektrische Netzwerkkomponente geschaltet ist.

Die Erfindung gibt auch ein Verfahren zum Herstellen einer Schaltung zum Leiten eines elektrischen Stromes zwischen einer Fahrzeugbatterie und einer an die Fahrzeugbatterie anschließbaren elektrischen Netzwerkkomponente über ein elektrisches Bauelement an, das die Schritte Anordnen eines ersten elektrischen Leitungsabschnitt und eines zweiten elektrischen Leitungsabschnittes mit einem Spalt zueinander, Einbringen eines Abstandshalters in den Spalt und Überbrücken des Spaltes mit dem Abstandshalter mit einem elektrischen Bauelement umfasst, so dass das elektrische Bauelement den ersten und zweiten Leitungsabschnitt miteinander elektrisch verbindet. Der Abstand zwischen dem ersten Leitungsabschnitt und dem zweiten Leitungsabschnitt ist von einer Durchschlagsfeldstärke des Abstandshalters abhängig. Die Leitungsabschnitte sind miteinander labyrinthartig verzahnt.

Das angegebene Herstellungsverfahren kann um Herstellungsverfahrensschritte erweitert werden, die die Merkmale der angegebenen Schaltung gemäß den Untersprüchen sinngemäß realisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht von Schaltungen, die auf einem Leadframe getragen sind;
Fig. 2 eine schematische Ansicht eine der Schaltungen aus Fig. 1;
Fig. 3 eine schematische Schnittansicht eines Teils der Schaltung aus Fig. 2;
Fig. 4 eine schematische Schnittansicht eines Teils der Schaltung aus Fig. 2;
Fig. 5 eine Seitenansicht der Schaltung aus Fig. 2 und
Fig. 6 eine alternative Seitenansicht der Schaltung aus Fig. 2 zeigen.

In den Figuren werden gleiche technische Elemente mit gleichen Bezugszeichen versehen und nur einmal beschrieben.

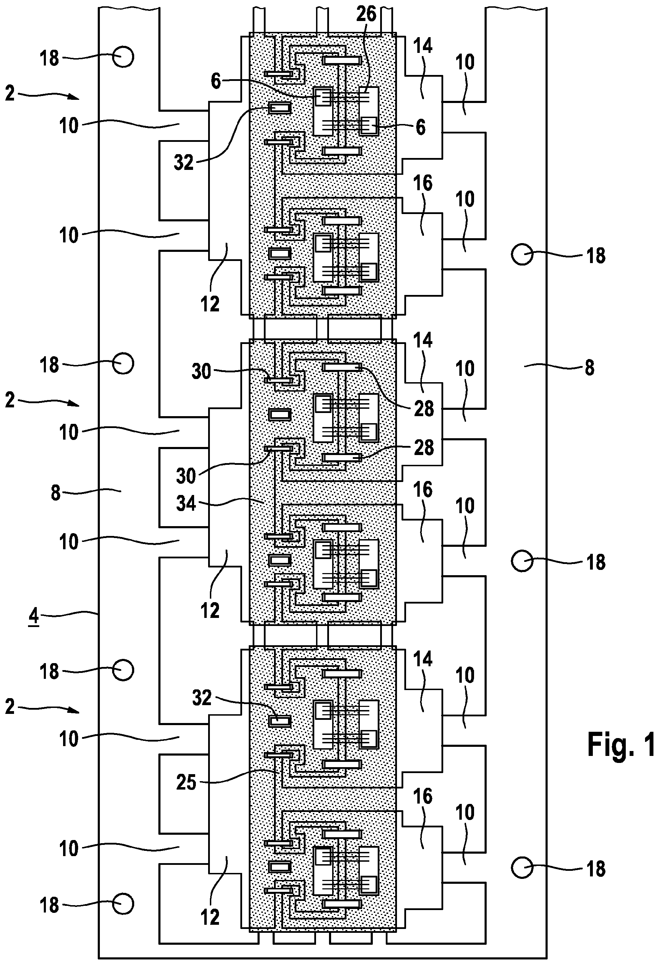

Es wird auf Fig. 1 Bezug genommen, die eine schematische Ansicht von Schaltungen 2 zeigt, die auf einem Leadframe 4 getragen sind.

Die Schaltungen 2 sollen in der vorliegenden Ausführung noch zu beschreibende Stromsensoren 6 tragen, die in Reihe zwischen eine nicht weiter dargestellte Fahrzeugbatterie und einen nicht weiter dargestellten elektrischen Verbraucher oder zwischen die Fahrzeugbatterie und einen nicht weiter dargestellten Stromanschluss zum Laden der Fahrzeugbatterie geschalten werden können. In Fig. 1 sind der Übersichtlichkeit halber nur einige der Stromsensoren 6 mit einem Bezugszeichen versehen. Die Stromsensoren 6 sollen den von der Fahrzeugbatterie abgegebenen oder den die Fahrzeugbatterie speisenden Strom messen, worauf basierend ein Ladezustand der Fahrzeugbatterie erfasst werden kann, der wiederum zum Energiemanagement der Fahrzeugbatterie verwendet werden kann.

Der Leadframe 4 weist in der vorliegenden Ausführung zwei Hauptschienen 8 auf, von denen rechtwinklig Stromsammeischienen 10, auch Stege 10 genannt, abragen, die mit noch zu beschreibenden elektrischen Anschlüssen 12, 14, 16 der Schaltungen 2 kontaktiert sind. Auf den Hauptschienen 8 sind Indexlöcher 18 ausgebildet, anhand derer die Längsabmessungen der Schaltungen 2 messtechnisch erfasst werden können, um die Schaltungen 2 automatisiert zu transportieren und separieren.

In Fig. 1 weist jede Schaltung drei Leitungsabschnitte 20, 22, 24 auf, die durch einen elektrisch isolierenden Spalt 25 voneinander mechanisch und elektrisch getrennt sind. In Fig. 1 ist der Übersichtlichkeit halber nur der Spalt 25 einer Schaltung 2 mit einem Bezugszeichen versehen. Dabei ist an jedem Leitungsabschnitt 20, 22, 24 einer der elektrischen Anschlüsse 12, 14, 16 ausgebildet. In der vorliegenden Ausführung soll ein erster der elektrischen Anschlüsse 12 mit der oben genannten Fahrzeugbatterie verbunden werden, so dass der erste Anschluss 12 nachstehend als Batterieanschluss 12 bezeichnet werden soll. Ein zweiter der elektrischen Anschlüsse 14 soll mit dem oben genannten elektrischen Verbraucher verbunden werden, so dass der zweite Anschluss 14 nachstehend als Verbraucheranschluss 14 bezeichnet werden soll. Ein dritter der Anschlüsse 16 soll mit dem oben genannten Stromanschluss verbunden werden, so dass der dritte Anschluss 16 nachstehend als Stromanschluss 16 bezeichnet werden soll. In entsprechender Nomenglatur werden nachstehend auch die Leitungsabschnitte 20, 22, 24 bezeichnet, an denen der Batterie-, Verbraucher- und Stromanschluss 12, 14, 16 entsprechend ausgebildet ist.

Auf jeder Schaltung 2 überbrücken nachstehend zwei Stromsensoren 6 zwei der Leitungsabschnitte 20, 22, 24, so dass entweder ein elektrischer Strom zwischen dem Batterieanschluss 12 und dem Verbraucheranschluss 14 oder zwischen dem Batterieanschluss 12 und dem Stromanschluss 16 fließen kann. Auf diese Weise kann eine an den Batterieanschluss 12 angeschlossene Fahrzeugbatterie über den Verbraucheranschluss 14 entladen und gegebenenfalls geladen sowie über den Stromanschluss 16 geladen und gegebenenfalls entladen werden.

Die Stromsensoren 6 sind dabei in der vorliegenden Ausführung auf einem der Leitungsabschnitte 20, 22, 24 getragen und mit diesem auch elektrisch kontaktiert und werden über eine Bondverbindung 26 mit dem jeweils weiteren Leitungsabschnitt 20, 22, 24 elektrisch kontaktiert. In Fig. 1 ist der Übersichtlichkeit halber nur eine der Bondverbindungen 26 mit einem Bezugszeichen versehen. Die Stromsensoren 6 können zwar beliebig ausgebildet sein, besonders bevorzugt sind die Stromsensoren 6 jedoch als aktive Shunts ausgebildet, die aus der DE 10 2011 078 548 A1 bekannt sind. Für weitere Einzelheiten zu diesen aktiven Shunts wird der Kürze halber auf diese Druckschrift verwiesen.

Weiter können die Leitungsabschnitte 20, 22, 24 noch EMV-und ESD-Kondensatoren 28 und Schutzschaltelemente 30 verbinden, die beispielsweise als Schutzdiode, Schutzkondensator oder als Schutzvaristor ausgebildet sein können. Die EMV-Kondensatoren dienen der Filterung unerwünschter Signalanteile aus dem zu leitenden Strom und verbessern so die elektromagnetische Verträglichkeit und die Festigkeit gegen elektrostatische Entladungen. In Fig. 1 sind der Übersichtlichkeit halber nur einige der EMV-Kondensatoren 28 und der Schutzschaltelemente 30 mit einem Bezugszeichen versehen.

Schließlich können auf dem Batterieleitungsabschnitt 12 und/oder einem der anderen Leitungsabschnitte 14, 16 Temperatursensoren 32 angeordnet sein, die zum Erfassen einer Temperatur der Schaltung 2 vorgesehen sein können, um bei einer Überhitzung der Schaltung 2 geeignete Schutzmaßnahmen einzuleiten. In Fig. 1 sind der Übersichtlichkeit halber nur einige der Temperatursensoren mit einem Bezugszeichen versehen. Neben dieser Überwachungsfunktion können die die Temperatursensoren auch zur Kennlinienkorrektur der elektrischen Bauelemente, wie beispielsweise in den Stromsensoren 6 enthaltene Feldeffekttransistoren verwendet werden.

Der oben beschriebene Spalt 25 ist damit zur Strommessung, zur Steigerung der elektromagnetischen Verträglichkeit (EMV) und der Festigkeit gegen elektrostatische Entladungen (ESD) sowie zur Implementierung der Schutzschaltelemente 30 notwendig. Es muss daher gesichert sein, dass die einzelnen Leitungsabschnitte 12, 14, 16 keinen elektrischen Kontakt untereinander haben.

Andererseits benötigen die einzelnen Leitungsabschnitte 20, 22, 24 aber auch einen gewissen mechanischen Grundhalt untereinander. Anderenfalls würden die Bonddrähte 26, die EMV-Kondensatoren 28 und die Schutzschaltelemente 30 zu starken mechanischen Zugbelastungen ausgesetzt sein, was die elektrische Kontaktierung dieser Bauelemente lösen oder die Bauelemente selbst beschädigen und die Schaltung 2 so funktionsuntüchtig machen könnte. Zudem können auch die Leitungsabschnitte 20, 22, 24 selbst verspannen und diese Verspannungen auf die elektrischen Bauelemente übertragen, die auf ihnen getragen sind, wie die Stromsensoren 6 und die Temperatursensoren 32, was auch hier zum Lösen der elektrischen Kontaktierung oder einer Beschädigung der Bauelemente selbst führen könnte.

Um diese Nachteile zu umgehen, wird in der vorliegende Ausführung daher vorgeschlagen, die Leitungsabschnitte 20, 22, 24 miteinander labyrintartig zu verzahnen und in einem Premoldmasse 34 einzubetten, so dass die Premoldmasse 34 die einzelnen Leitungsabschnitte 20, 22, 24 steif zusammenhält.

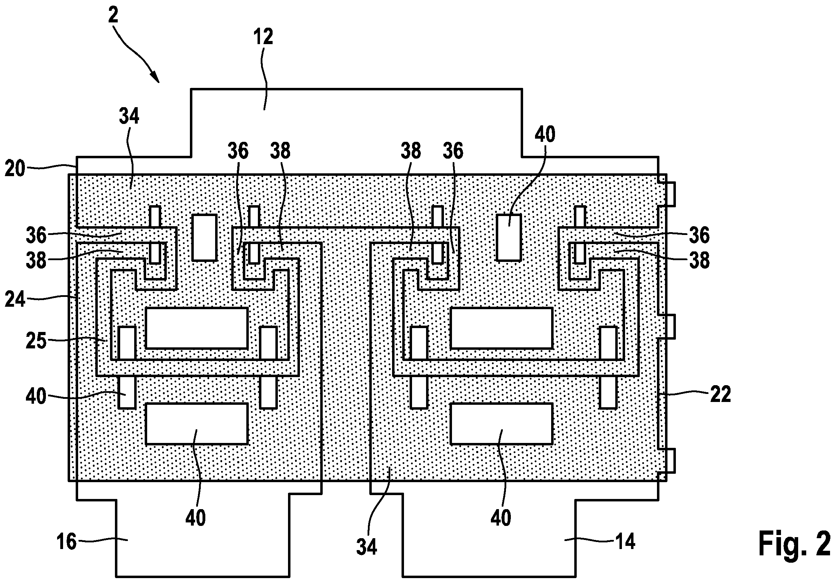

Dies soll nachstehend anhand der Fig. 2 näher erläutert werden, die eine schematische Ansicht eine der Schaltungen 2 aus Fig. 1 ohne die bestückten Bauelemente, wie die Stromsensoren 6, die Bonddrähte 26, die EMV-Kondensatoren 28 und die Schutzschaltelemente 30 und die Temperatursensoren 32 zeigt.

Wie aus Fig. 2 zu sehen, weist der Batterieleitungsabschnitt 20 Labyrinthe 36 auf, in die die Arme 38 eingreifen, die am Verbraucherleitungsabschnitt 22 und am Stromleitungsabschnitt 24 entsprechend ausgebildet sind. Die Arme 38 weisen dabei den gleichen labyrinthförmigen Verlauf auf, wie die Labyrinthe 36, sind jedoch schmaler ausgebildet, so dass zwischen den Leitungsabschnitten 20, 22, 24 der elektrisch isolierende Spalt 25 verbleibt. Durch die in die Labyrinthe 36 eingreifenden Arme 38 werden die Leitungsabschnitte 20, 22, 24 labyrinthförmig verzahnt und damit verschränkt.

Um den mechanischen Halt zwischen den Leitungsabschnitten 20, 22, 24 zu halten wird wenigstens der Spalt 25 mit der Premoldmasse 34 ausgegossen. In der vorliegenden Ausführung werden jedoch die gesamten Leitungsabschnitte 20, 22, 24 mit der Premoldmasse 34 überzogen, wobei Öffnungen 40 verbleiben, in die die in Fig. 1 gezeigten und oben genannten elektrischen Bauelemente eingesetzt werden und mit den Leitungsabschnitten 20, 22, 24 kontaktiert werden können. Darauf wird an späterer Stelle näher eingegangen. In Fig. 2 sind der Übersichtlichkeit halber nur einige der Öffnungen 40 mit einem Bezugszeichen versehen.

Werden in dem in Fig. 2 gezeigten Aufbau zwei der Leitungsabschnitte 20, 22, 24 gegeneinander auf Zug oder Druck belastet führt dies dazu, dass das Material der Premoldmasse 34 im Spalt 25 an einer Stelle komprimiert wird, während es an einer anderen Stelle auseinandergezogen wird. Auf diese Weise wirken zwei verschiedene durch die Premoldmasse 34 aufgebrachten Gegenkräfte gegen die Zug- oder Druckbelastung, wodurch die Leitungsabschnitte 20, 22, 24 mechanisch fest an ihren relativen Positionen zueinander gehalten werden.

Dadurch, dass sich die Premoldmasse 34 zusätzlich auch über die Oberfläche der Leitungsabschnitte 20, 22, 24 erstreckt, wird verhindert, dass sich die Leitungsabschnitte 20, 22, 24 innerlich verdrehen und so Oberflächenspannungen entstehen, die dann auf die oben genannten Bauelemente übertragen werden könnten. Damit ist eine elektrisch beständige und mechanisch stabile Schaltung 2 gegeben, die auch höchsten Zuverlässigkeitsanforderungen entspricht, wie sie beispielsweise in der Automobiltechnik erwartet werden.

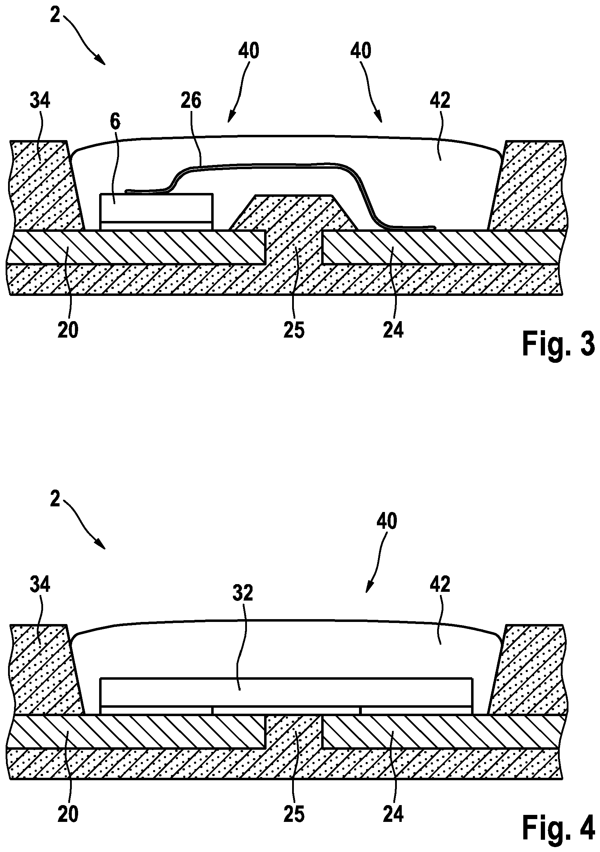

Es wird auf Fig. 3 Bezug genommen, die eine schematische Schnittansicht eines Teils der Schaltung 2 aus Fig. 2 zeigt.

In Fig. 3 ist ein Teil des Batterieleitungsabschnittes 12 und des Stromleitungsabschnittes 24 gezeigt, die durch den Spalt 25 elektrisch getrennt sind, wobei der Spalt 25 über den Stromsensor 6 sowie die Bondverbindung 26 elektrisch überbrückt ist, so dass über den Stromsensor 6 ein elektrischer Strom zwischen den beiden Leitungsabschnitten 20, 24 fließen kann.

Der Stromsensor 6 sowie die Bondverbindungen 26 sind in der vorliegenden Ausführung von einer aus einem Globetop- oder Silgelmaterial bestehender Schutzmasse 42 umgeben, das den Stromsensor 6 sowie die Bondverbindungen 26 vor eindringender Feuchtigkeit und anderen Verschmutzungen schützt.

Die Leitungsabschnitte 20, 22, 24 können mit dem Premoldmaterial 34 beispielsweise umspritzt werden, so dass ein Teil des Premoldmaterials 34 durch den Spalt 25 hindurchtritt. Daher ist befindet sich unterhalb der Bondverbindung 26 im Bereich des Spaltes 25 eine kleinere Ansammlung an Premoldmaterial 34, die eine zusätzliche Verankerung der Leitungsabschnitte 20, 22, 24 in der Premoldmasse 34 bewirkt.

Es wird auf Fig. 4 Bezug genommen, die eine schematische Schnittansicht eines Teils der Schaltung aus Fig. 2, in der ein Schutzschaltelement 32 zwischen dem Batterieleitungsabschnitt 12 und dem Stromleitungsabschnitt 16 elektrisch kontaktiert ist.

Wie aus Fig. 4 zu sehen, ist das Schutzschaltelement 32 in der vorliegenden Ausführung direkt mit den Leitungsabschnitten 20, 24 ohne eine weitere Bondverbindung elektrisch kontaktiert. Es muss daher gewährleistet sein, dass unter dem Schutzschaltelement 32 keine Ansammlung von Premoldmaterial 34 vorhanden ist. Dies kann entweder dadurch gesichert werden, dass der Spalt beim Umspritzen der Leitungsabschnitte 20, 24 in der Öffnung 40 abgedeckt, oder dass das Premoldmaterial 34 nach dem Umspritzen der Leitungsabschnitte 20, 24 in der Öffnung 40 abgetragen wird.

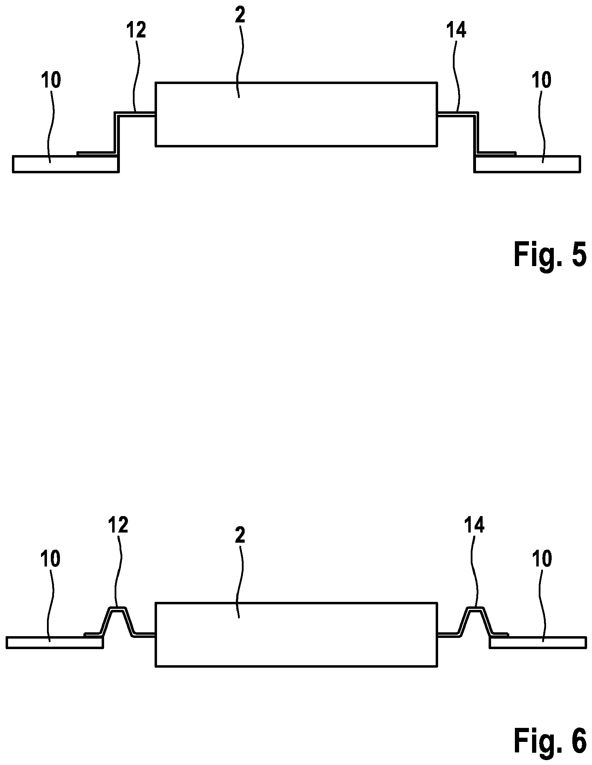

Es wird auf Fig. 5 Bezug genommen, die eine Seitenansicht der mit dem Premoldmaterial 34 umspritzten Schaltung 2 aus Fig. 2 zeigt, wobei an die Schaltung 2 die in Fig. 1 gezeigten Stromsammelschienen 10 elektrisch angeschlossen sind.

Wie in Fig. 5 zu sehen, können die Anschlüsse 12, 14, 16, von denen in Fig. 5 beispielhaft der Batterieanschluss 12 und der Verbraucheranschluss 14 gezeigt ist, abgebogen sein. Auf diese Weise können sich die Anschlüsse 12, 14, 16 winklig zur Schaltung 2 mechanisch ausdehnen, so dass die Anschlüsse keine mechanischen Belastungen, beispielsweise durch Wärmeausdehnung in die Schaltung 2 einbringen.

In Fig. 6 ist ein alternatives Beispiel zur Ausbildung der Abschlüsse 12, 14, 16 gezeigt, um eine mechanische Ausdehung rechtwinklig zur Schaltung 2 zuzulassen. In Fig. 6 sind die Anschlüsse 12, 14, 16 gefaltet, wodurch sich die Anschlüsse zusammenschieben können und so selbst mechanische Ausdehnungen in Richtung der Schaltung 2 aufnehmen können.

## Patentansprüche

1. Schaltung (2) zum Leiten eines elektrischen Stromes zwischen einer Fahrzeugbatterie und einer an die Fahrzeugbatterie anschließbaren elektrischen Netzwerkkomponente über ein elektrisches Bauelement (6, 28, 30), umfassend einen ersten elektrischen Leitungsabschnitt (20, 22, 24) und einen über einen Abstandshalter (34) vom ersten Leitungsabschnitt (20, 22, 24) getrennten zweiten Leitungsabschnitt (20, 22, 24), wobei die Leitungsabschnitte (20, 22, 24) über das elektrische Bauelement (6, 28, 30) miteinander verbunden sind, **wobei** ein Abstand zwischen dem ersten Leitungsabschnitt (20, 22, 24) und dem zweiten Leitungsabschnitt (20, 22, 24) von einer Durchschlagsfeldstärke des Abstandshalters (34) abhängig ist,
**dadurch gekennzeichnet, dass**
die Leitungsabschnitte (20, 22, 24) miteinander labyrinthartig verzahnt (36, 38) sind.

2. Schaltung (2) nach Anspruch 1, wobei die labyrinthartige Verzahnung (36, 38) der Leitungsabschnitte (20, 22, 24) federnd ausgebildet ist.

3. Schaltung (2) nach einem der vorstehenden Ansprüche, wobei der Abstandshalter (34) ein Premoldmaterial ist.

4. Schaltung (2) nach Anspruch 3, wobei das Premoldmaterial (34) eine Oberfläche der elektrischen Leitungsabschnitte (20, 22, 24) derart umschließt, dass eine Öffnung (40) zum elektrischen Kontaktieren des elektrischen Bauelements (6, 28, 30) auf den Leitungsabschnitten (20, 22, 24) frei bleibt.

5. Schaltung (2) nach einem der vorstehenden Ansprüche, wobei Kontaktflächen auf den Leitungsabschnitten (20, 22, 24) zum Kontaktieren des elektrischen Bauelementes (6, 28, 30) beschichtet sind.

6. Schaltung (2) nach einem der vorstehenden Ansprüche, umfassend das elektrische Bauelement (6, 28, 30), das von einer Schutzmasse (42) bedeckt ist.

7. Schaltung (2) nach einem der vorstehenden Ansprüche, wobei die Leitungsabschnitte (20, 22, 24) auf einem Bauteilträger (4), Leadframe genannt, getragen sind.

8. Verfahren zum Herstellen einer Schaltung (2) zum Leiten eines elektrischen Stromes zwischen einer Fahrzeugbatterie und einer an die Fahrzeugbatterie anschließbaren elektrischen Netzwerkkomponente über ein elektrisches Bauelement (6, 28, 30), umfassend Anordnen eines ersten elektrischen Leitungsabschnitt (20, 22, 24) und eines zweiten elektrischen Leitungsabschnittes (20, 22, 24) mit einem Spalt (25) zueinander, Einbringen eines Abstandshalters (34) in den Spalt und Überbrücken des Spaltes (25) mit dem Abstandshalter (34) mit dem elektrischen Bauelement (6, 28, 30), so dass das elektrische Bauelement (6, 28, 30) den ersten und zweiten Leitungsabschnitt (20, 22, 24) miteinander elektrisch verbindet, wobei ein Abstand zwischen dem ersten Leitungsabschnitt (20, 22, 24) und dem zweiten Leitungsabschnitt (20, 22, 24) von einer Durchschlagsfeldstärke des Abstandshalters (34) abhängig ist, und wobei die Leitungsabschnitte (20, 22, 24) miteinander labyrinthartig verzahnt (36, 38) sind.
ten und zweiten Leitungsabschnitt (20, 22, 24) miteinander elektrisch verbindet.

## Claims

1. Circuit (2) for conducting an electric current between a vehicle battery and an electrical network component which can be connected to the vehicle battery via an electrical element (6, 28, 30), comprising a first electrical line section (20, 22, 24) and a second line section (20, 22, 24), which is separated from the first line section (20, 22, 24) via a spacer (34), wherein the line sections (20, 22, 24) are connected to one another via the electrical element (6, 28, 30), **wherein** a distance between the first line section (20, 22, 24) and the second line section (20, 22, 24) is dependent on a breakdown field strength of the spacer (34), **characterized in that**
the line sections (20, 22, 24) are interlocked (36, 38) with one another in labyrinth-like fashion.

2. Circuit (2) according to Claim 1, wherein the labyrinth-like interlocking (36, 38) of the line sections (20, 22, 24) is resilient.

3. Circuit (2) according to either of the preceding claims, wherein the spacer (34) is a premold material.

4. Circuit (2) according to Claim 3, wherein the premold material (34) envelops a surface of the electrical line sections (20, 22, 24) in such a way that an opening (40) for making electrical contact with the electrical element (6, 28, 30) remains free on the line sections (20, 22, 24).

5. Circuit (2) according to one of the preceding claims, wherein contact areas on the line sections (20, 22, 24) for making contact with the electrical element (6, 28, 30) are coated.

6. Circuit (2) according to one of the preceding claims, comprising the electrical element (6, 28, 30), which is covered by a protective compound (42).

7. Circuit (2) according to one of the preceding claims, wherein the line sections (20, 22, 24) are mounted on a component part mount (4), referred to as leadframe.

8. Method for producing a circuit (2) for conducting an electric current between a vehicle battery and an electrical network component which can be connected to the vehicle battery via an electrical element (6, 28, 30), comprising arranging a first electrical line section (20, 22, 24) and a second electrical line section (20, 22, 24) with a gap (25) with respect to one another, introducing a spacer (34) into the gap, and bridging the gap (25) having the spacer (34) with the electrical element (6, 28, 30), with the result that the electrical element (6, 28, 30) electrically connects the first and second line sections (20, 22, 24) to one another, wherein a distance between the first line section (20, 22, 24) and the second line section (20, 22, 24) is dependent on a breakdown field strength of the spacer (34), and wherein the line sections (20, 22, 24) are interlocked (36, 38) with one another in labyrinth-like fashion.

## Revendications

1. Circuit (2) destiné à la conduction d'un courant électrique entre une batterie de véhicule et un composant de réseau électrique pouvant être connecté à la batterie de véhicule par le biais d'un composant électrique (6, 28, 30), lequel circuit comprend un premier tronçon de ligne électrique (20, 22, 24) et un deuxième tronçon de ligne (20, 22, 24) séparé du premier tronçon de ligne (20, 22, 24) par un dispositif d'écartement (34), dans lequel les tronçons de ligne (20, 22, 24) sont reliés l'un à l'autre par le composant électrique (6, 28, 30), dans lequel une distance entre le premier tronçon de ligne (20, 22, 24) et le deuxième tronçon de ligne (20, 22, 24) dépend d'une intensité de champ de claquage du dispositif d'écartement (34),
**caractérisé en ce que** les tronçons de ligne (20, 22, 24) sont imbriqués en labyrinthe (36, 38) les uns avec les autres.

2. Circuit (2) selon la revendication 1, dans lequel l'imbrication en labyrinthe (36, 38) des tronçons de ligne (20, 22, 24) est réalisée de manière élastique.

3. Circuit (2) selon l'une des revendications précédentes, dans lequel le dispositif d'écartement (34) est un matériau pré-moulé.

4. Circuit (2) selon la revendication 3, dans lequel le matériau pré-moulé (34) entoure une surface des tronçons de ligne électriques (20, 22, 24) de manière à ce qu'une ouverture (40) permettant la mise en contact électrique du composant électrique (6, 28, 30) sur les tronçons de ligne (20, 22, 24) reste libre.

5. Circuit (2) selon l'une des revendications précédentes, dans lequel les surfaces de contact sont revêtues sur les tronçons de ligne (20, 22, 24) pour la mise en contact du composant électrique (6, 28, 30).

6. Circuit (2) selon l'une des revendications précédentes, comprenant le composant électrique (6, 28, 30) qui est revêtu par une masse de protection (42).

7. Circuit (2) selon l'une des revendications précédentes, dans lequel les sections de ligne (20, 22, 24) sont portées par un support de composants (4), désigné grille de connexion.

8. Procédé de fabrication d'un circuit (2) pour la conduction d'un courant électrique entre une batterie de véhicule et un composant de réseau électrique pouvant être connecté à la batterie de véhicule par le biais d'un composant électrique (6, 28, 30), comprenant la mise en place d'un premier tronçon de ligne électrique (20, 22, 24) et d'un deuxième tronçon de ligne électrique (20, 22, 24) séparés par un espace (25), l'insertion d'un dispositif d'écartement (34) dans ledit espace et le pontage de l'espace (25) au moyen du dispositif d'écartement (34) muni du composant électrique (6, 28, 30) de manière à ce que le composant électrique (6, 28, 30) relie l'un à l'autre électriquement les premier et deuxième tronçons de ligne (20, 22, 24), dans lequel une distance entre le premier tronçon de ligne (20, 22, 24) et le deuxième tronçon de ligne (20, 22, 24) dépend d'une intensité de champ de claquage du dispositif d'écartement (34) et dans lequel les tronçons de ligne (20, 22, 24) sont imbriqués labyrinthe (36, 38) les uns avec les autres.
